# EUROPEAN PATENT APPLICATION

(11) **EP 2 664 946 A2**
(43) Date of publication of application: **20.11.2013**
(21) Application number: 13167277.6
(22) Date of filing: 10.05.2013
(51) Int. Cl.: G01V 8/14

(54) **Photoelectric sensor**

(30) Priority: 15.05.2012 JP 2012111525
(71) Applicant: OMRON CORPORATION, Kyoto-shi, Kyoto 600-8530 (JP)
(72) Inventor: Shimizu, Tetsu, Kyoto-shi, Kyoto 600-8530 (JP); Okuno, Motoharu, Kyoto-shi, Kyoto 600-8530 (JP); Tsuzuki, Ryosuke, Kyoto-shi, Kyoto 600-8530 (JP); Kawai, Takehiro, Kyoto-shi, Kyoto 600-8530 (JP)
(74) Representative: Horn Kleimann Waitzhofer

(57) **Abstract**

A photodiode is downsized within a range that can deal with variation of a light incident position. In a photoelectric sensor including a projection unit that includes a projection element (LED) and a photo-IC that includes the photodiode and a signal processing circuit, an element body of the photodiode has a front surface, a rear surface, and a cross-section therebetween formed into a shape of a rectangle in which four corners thereof are eliminated, the rectangle having an area larger than that of a spot image formed by light passing through a light receiving lens in front. For example, based on a conceivable deviation range of the spot image, the minimum rectangle including the deviation range is set, four corner portions of the rectangle are cut out to form an octagon, and the shape and size of the octagon is applied to the element body of the photodiode.

## Description

### BACKGROUND OF THE INVENTION

### 1. TECHNICAL FIELD

The present invention relates to a photoelectric sensor in which a light receiving part includes an IC chip (a photo-IC), in which a photodiode and a signal processing circuit are incorporated.

### 2. RELATED ART

For example, Japanese Unexamined Patent Publication Nos. 2007-13050 and 2005-303264 disclose photoelectric sensors in each of which the photo-IC is used as the light receiving part.
In a configuration of the reflection-type photoelectric sensor disclosed in Japanese Unexamined Patent Publication No. 2007-13050, an LED (Light Emitting Diode) and the photo-IC are mounted side by side on a substrate in which a circuit pattern is formed, and a light shielding wall is provided between the LED and the photo-IC (see paragraphs [0015], [0016], Fig. 2, and the like of Japanese Unexamined Patent Publication No. 2007-13050).

Japanese Unexamined Patent Publication No. 2005-303264 discloses the reflection-type photoelectric sensor having a configuration in which a holder equipped with a lens is disposed in front of the substrate on which the LED and the photo-IC are mounted, and the photo-IC having a configuration in which the square photodiode is disposed in a central portion (see paragraphs [0031] to [0032], Figs. 2, 3, and the like of Japanese Unexamined Patent Publication No. 2005-303264). In Japanese Unexamined Patent Publication No. 2005-303264, the photo-IC having the similar configuration is incorporated in an optical receiver of the transmission-type photoelectric sensor.

Nowadays, in the site in which the photoelectric sensor is used, a detection target is diversified, and downsizing of a facility is advanced. Therefore, there is an increasing demand of users for a compact, high-performance photoelectric sensor.

In order to meet the demand, it is necessary to downsize the photodiode. When the photodiode is downsized, the photo-IC is also downsized.
In an element body of the photodiode, a parasitic capacitance is generated in a junction portion between a P-type semiconductor and an N-type semiconductor. With increasing sectional area of the junction portion, the parasitic capacitance is increased to degrade response to a control signal issuing an instruction to receive light. In the case where signal processing of converting a current generated by photoelectric conversion into a voltage is performed using a transimpedance amplifier, a noise caused by the parasitic capacitance overlaps a light receiving amount signal. In order to improve the detection performance of the sensor, it is necessary to reduce the parasitic capacitance as small as possible. Therefore, it is necessary to downsize the photodiode.

However, in the photoelectric sensor, a variation of an image formation position of a spot image is generated in each product by a minute deviation between components during assembly and a deviation of the photodiode in the photo-IC. In order to stably perform the detection, it is necessary form the spot image having a sufficient size in a light receiving surface even if the light is incident to any position. Therefore, the photodiode is hardly downsized.

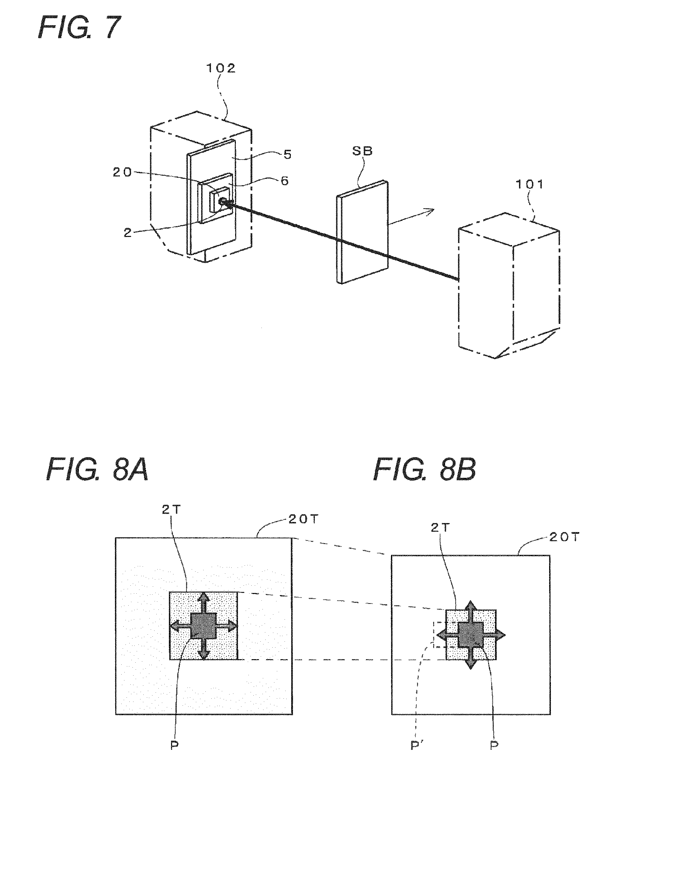

Figs. 8A and 8B specifically illustrate a problematic point when the photodiode is downsized.
Figs. 8A and 8B illustrate a photodiode 2T, and the photodiode 2T is incorporated in a photo-IC 20T. The element body of the photodiode 2T generally has a square shape, and is mounted on a silicon substrate in the photo-IC 20T. A wiring pattern of a circuit that processes a signal from the photodiode 2T is provided around the photodiode 2T on the silicon substrate. In order to form all the wiring patterns of the necessary circuits, it is necessary to ensure a region having a given area. As illustrated in Fig. 8B, when the photodiode 2T is downsized, the photo-IC 20T can be downsized while the area of the wiring pattern is maintained.

A spot image P is not always formed in the central portion of the photodiode 2T by the incidence of the detection light, but the spot image P may be formed while deviated in various directions as indicated by arrows in four directions in Figs. 8A and 8B. Therefore, when the photodiode 2T is downsized, in the case where the spot image P is greatly deviated as indicated by a dotted-line frame P' in Fig. 8B, the light receiving amount is greatly decreased to degrade sensitivity.

### SUMMARY

The present invention has been devised to solve the problems described above, and an object thereof is to provide a photoelectric sensor in which downsizing of a photodiode and a photo-IC equipped therewith is implemented by downsizing the photodiode within a range that can deal with the variation of light incidence position, and to improve the detection performance of the photoelectric sensor.

In accordance with one aspect of the present invention, a photoelectric sensor includes: a projection element that emits detection light; a silicon substrate on which a signal processing circuit is formed; and a photo-IC that includes a photodiode mounted on the silicon substrate, wherein the light emitted from the projection element or reflected light is received by the photodiode, and a detection signal is output based on an output from the signal processing circuit that processes a light receiving amount signal generated by the light reception of the photodiode.
The present invention is **characterized in that**, in the photodiode of the photo-IC, an element body of the photodiode has a front surface, a rear surface, and a cross-section between the front surface and the rear surface formed into a shape of a rectangle in which at least one of four corners thereof is eliminated, the rectangle having an area larger than that of a spot image formed in a front surface of the element body by light passing through a light receiving lens in front.

In the light receiving surface (a front surface of the element body) of the photodiode, the light incident position varies depending on various causes. However, the variation range of the image formation position of the spot image due to the deviation is conceivable by experience or measurement. In the conventional square photodiode, even if the area is reduced as much as possible within the range including the conceivable range, an unnecessary region where the spot image is not formed is generated in each of the four corner portions.

In the present invention, based on the above consideration, the element body of the photodiode is reduced within the range where the detection light is received without any trouble by changing the surfaces of the element body to the shape in which the unnecessary region is eliminated. The shape of the reduced element body is applied to the whole thick portion of the element body, so that an area of a junction surface of a P-type semiconductor and an N-type semiconductor can be reduced to decrease the parasitic capacitance.

In one embodiment of the photoelectric sensor, the element body of the photodiode has the front surface, the rear surface, and the cross-section between the front surface and the rear surface formed into an octagonal shape obtained by cutting out all the four corners of the rectangle. The shape of the outer edge portion of the element body can be determined by setting to each corner portion the straight line obliquely traversing the corner portion such that the unnecessary region generated in the corner portion is cut out. Therefore, the element body of the photodiode is easy to design. Because of the simple shape of the photodiode, the photodiode can be easily produced while suppressing the cost increase.

In a preferred embodiment, a wiring pattern of the signal processing circuit is formed around the element body of the photodiode on the silicon substrate, and part of the wiring pattern of the signal processing circuit is disposed in a place on the silicon substrate, which corresponds to the cut-out corner of the element body of the photodiode on the silicon substrate. When the wiring of the signal processing circuit is routed in the region where the corner portion of the element body is located in the past, the outer edge portion of the wiring range of the signal processing circuit and the substrate can be reduced without providing the fine wiring, and the main body of the photo-IC can be downsized.

According to the present invention, the photodiode of the photo-IC can be downsized within the range that can deal with the variation of the image formation position of the received light. Because the parasitic capacitance of the photodiode can be reduced by such downsizing, the response to the control signal is improved, the noise component generated by the signal processing is reduced, and the detection performance of the photoelectric sensor can be enhanced. Further, since the wiring of the signal processing circuit can be disposed in the place where the corner portion was present in the element body of the photodiode, the photo-IC can be downsized and therefore the photoelectric sensor can be downsized.
Furthermore, the wiring range can be reduced without providing the fine wiring in the signal processing circuit, so that the cost necessary for the downsizing can be suppressed.

### BRIEF DESCRIPTION OF THE DRAWINGS

Figs. 1A to 1C are views illustrating a schematic configuration of a reflection-type photoelectric sensor to which the present invention is applied together with a detection principle;
Fig. 2 is a view illustrating a configuration of an optical system of the photoelectric sensor in Figs. 1A to 1C;
Figs. 3A to 3D are views illustrating a method for forming a shape of an element body of a photodiode;
Fig. 4 is a view illustrating a reduction amount of an area that is generated by forming the element body of the photodiode into an octagon;
Figs. 5A and 5B are views illustrating changes of wiring range and size, which are generated in a photo-IC by changing an outer-edge shape of the element body of the photodiode from a rectangle to the octagon;
Figs. 6A to 6E are views illustrating shapes that can be applied to the element body of the photodiode;
Fig. 7 is a view illustrating a schematic configuration of a transmission-type photoelectric sensor to which the present invention is applied together with a detection principle; and
Figs. 8A and 8B are views illustrating a problematic point when a square photodiode is downsized.

### DETAILED DESCRIPTION

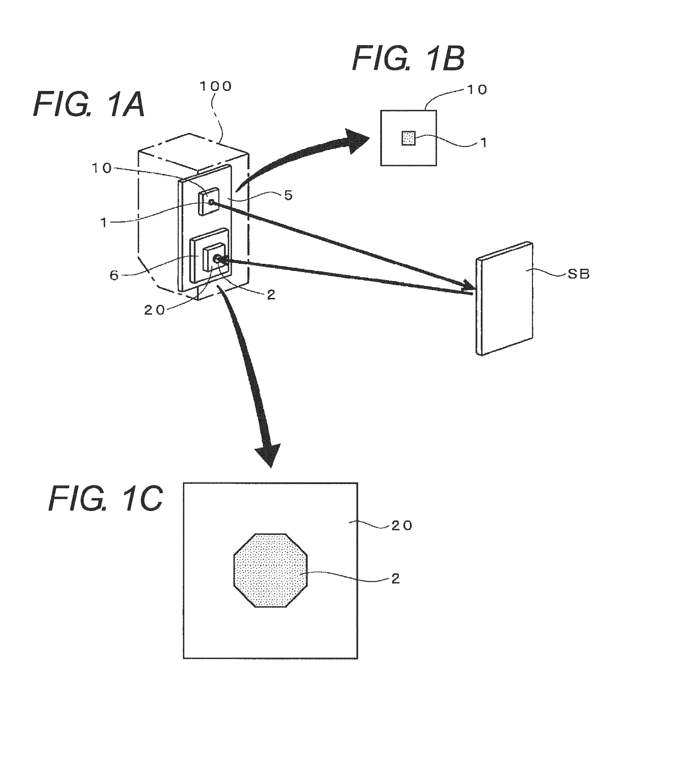

Figs. 1A to 1C are views illustrating a schematic configuration of a photoelectric sensor to which the present invention is applied together with a detection principle.
The photoelectric sensor of this example is a reflection-type sensor. In the photoelectric sensor, a detection area is irradiated with light, and an object SB is detected by receiving the light reflected from the object SB existing in the detection area.

As illustrated in Fig. 1A, a projection unit 10 including an LED 1 and a photo-IC 20 including a photodiode 2 are disposed in a casing 100 of the sensor while being mounted on a circuit board 5. The projection unit 10 is directly attached to the circuit board 5, and the photo-IC 20 is mounted on the circuit board 5 with an interposer 6 interposed therebetween.

Fig. 1B is an enlarged front view of the projection unit 10, and Fig. 1C is an enlarged front view of the photo-IC 20. Although front surfaces of the projection unit 10 and photo-IC 20 are actually coated with a transparent resin, the projection unit 10 and the photo-IC 20 are illustrated with the transparent resin removed in Figs. 1B and 1C.

Generally, in the photoelectric sensor, a square-chip LED is often used in consideration of cost. As illustrated in Fig. 1A, the LED 1 of the projection unit 10 of this embodiment also uses the square type LED. Similarly, the photodiode having the square element body is generally used in the photo-IC. However, as illustrated in Fig. 1B, the photodiode 2 of the photo-IC 20 of this embodiment has the element body in which the outer edge portion is formed into a regular octagonal shape.

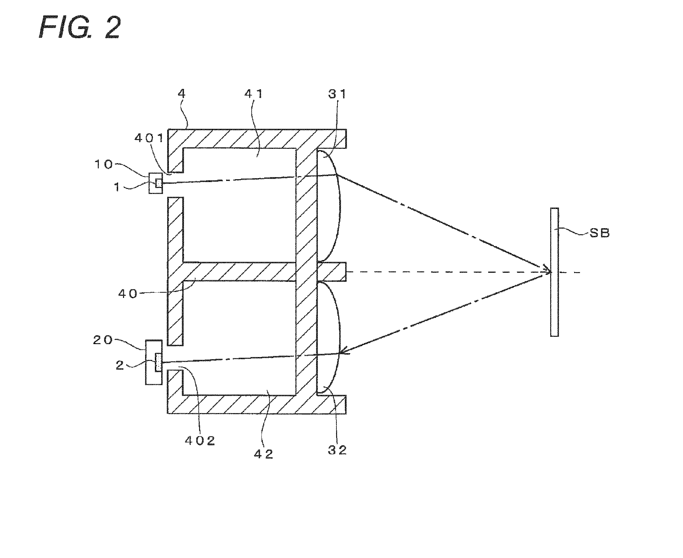

Fig. 2 illustrates an entire configuration of an optical system of the photoelectric sensor.
The optical system of this embodiment is configured by the projection unit 10, the photo-IC 20, a projection lens 31, a light receiving lens 32, and a holder 4 that supports the lenses 31 and 32. An inside of the holder 4 is divided into two light guide paths 41 and 42 by a central wall 40, the projection lens 31 is attached to a front end portion of the light guide path 41, and the light receiving lens 32 is attached to a front end portion of the light guide path 42. Apertures 401 and 402 are formed in rear end faces of the light guide paths 41 and 42, respectively.

Although not illustrated in Fig. 2, the circuit board 5 (see Figs. 1A to 1C) on which the projection unit 10 and the photo-IC 20 are mounted is attached to a board holder (not illustrated) connected to a backside of the holder 4 while a surface of the circuit board 5 is aligned in a vertical direction in Fig. 2. When the circuit board 5 is attached to the board holder, the LED 1 of the projection unit 10 is opposed to the aperture 401 of the light guide path 41, and the photodiode 2 of the photo-IC 20 is opposed to the aperture 402 of the light guide path 42.

When the LED 1, the photodiode 2, and the lenses 31 and 32 are aligned as described above, the light emitted from the LED 1 is guided to the projection lens 31 through the light guide path 41, and output as detection light from the projection lens 31. The light, which is reflected by the object SB to be detected and incident to the light receiving lens 32, is guided to the photodiode 2 through the light guide path 42.

When an image of the light guided to the photodiode 2 is formed in a light receiving surface at a front end of the element body, a spot image having a predetermined size is generated, and a variation of an image formation position is generated among products due to an error generated in the alignment during assembly. For example, the position or a deviation amount of the spot image fluctuates with respect to the center position by a minute deviation of the projection unit 10 or the photo-IC 20 with respect to the board 5, minute deviations of the attachment positions of the lenses 31 and 32 with respect to the holder 4, a deviation of the LED 1 of the projection unit 10 or the photodiode 2 of the photo-IC 20, and degrees of the deviations.

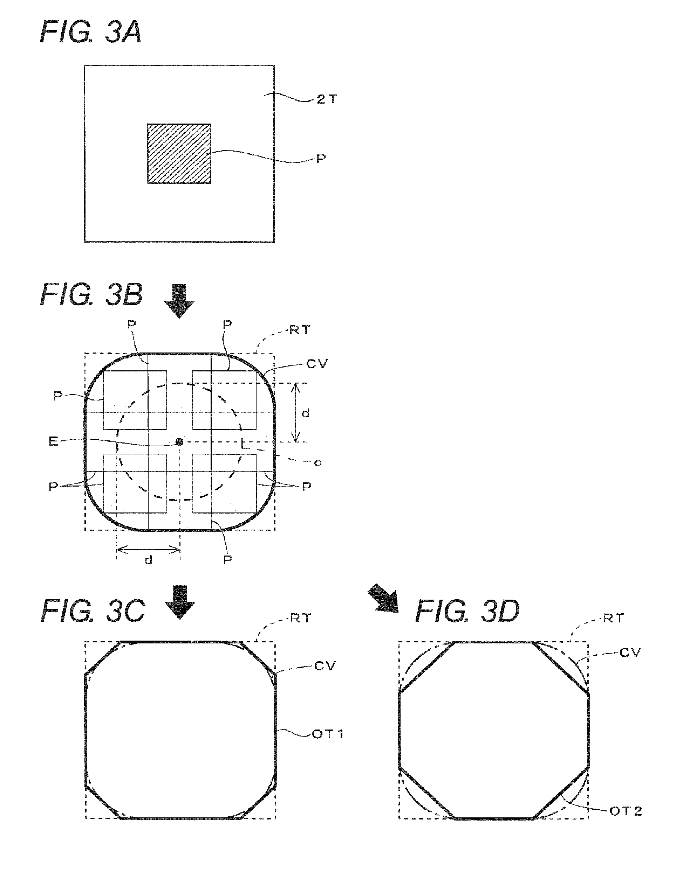

The shape of the element body of the photodiode 2 in Fig. 1C is formed in consideration of the variation. A method of forming the shape of the element body will be described below with reference to Figs. 3A to 3D.

Fig. 3A illustrates a state in which a spot image P is formed by the reflected light in the center portion of the element body of a conventional square photodiode 2T. In this example, the square spot image is formed. However, the shape of the spot image varies by an influence of characteristics of the lenses 31 and 32 or an optical length.

A point E in Fig. 3B is a reference point (the center point of the light receiving surface) at which the spot image P should be formed. As illustrated in Fig. 3B, assuming that d is a maximum deviation amount of the spot image P, the light receiving spot is deviated by a distance d in each direction from the reference point E at which the spot image P should be formed (that is, the center point of the spot image P is set on a circumference of a circle c having a radius d and the center point E, and the spot image P goes around), and the points located outermost in the spot images P are connected. Therefore, a closed curve having a shape indicated by a thick line CV in Fig. 3B can be obtained.

It is considered that the closed curve CV indicates a variation range of the spot image P. A symbol RT in Fig. 3B designates a minimum rectangle (in this case, the square) including the variation range, and corresponds to the shape of the element body of the photodiode 2T in Fig. 3A. As indicated by a relationship between the rectangle RT and the closed curve CV, even if the square photodiode 2T is minimized within the range that can deal with the variation of the image formation position of the spot image P, an unnecessary region where the spot image P is not formed is generated in each of four corner portions. Because the square shape is applied to not only the light receiving surface but also a whole thick portion of the element body, the unnecessary region is also generated in a junction surface between a P-type semiconductor and an N-type semiconductor of the photodiode 2T, and a parasitic capacitance of the photodiode 2T is increased to degrade detection performance of the sensor.

On the other hand, in the photodiode in which the outer edge portion is reduced to the range indicated by the closed curve CV, the unnecessary regions in the corner portions are eliminated, so that the detection performance can be enhanced by decreasing the parasitic capacitance. The surface in which the outer edge portion is formed by the closed curve CV includes all the image formation positions of the spot images P within the conceivable range, so that the spot image can be reliably formed by the reflected image. Therefore, the accurate detection can stably be performed.

Although the element body having the shape in which the four corners are rounded may be formed correctly according to the closed curve CV, as illustrated in Fig. 3C, a place where the closed curve CV has a large curvature (a place corresponding to the corner portion of the rectangle RT) may be replaced with a line segment circumscribing the closed curve CV, and a resultant octagon OT1 may be applied to a front surface and a rear surface of the element body and a cross-section between the front surface and the rear surface.

In the methods illustrated in Figs. 3A, 3B, and 3C, based on an empirical value or an experiment, the maximum value d of the deviation of the spot image P is specified with high accuracy to form the octagon OT1, and the photodiode having the outer edge portion to which the shape of the octagon OT1 is applied is produced, which allows the reflected light to be reliably received. The parasitic capacitance of the photodiode can also be reduced.

However, actually, the maximum value d of the deviation of the spot image P is conceivable within the range where reliability can be ensured to some extent. The octagon OT1 obtained by the above method corresponds to one in which the corner portion of each of the four corners of the rectangle RT having the minimum size including the variation range of the spot image P is cut out at the outside of the closed curve CV indicating the variation range. Alternatively, as illustrated in Fig. 3D, a shape of a regular octagon OT2 may be formed by a method of cutting out the corner portion along a line inside the closed curve CV.

The deviation of the spot image P is generated by a combination of various causes, and the combination of the causes varies according to a situation during the production of each product. Therefore, it is considered that a probability distribution of measured values becomes close to a normal distribution when the probability distribution is obtained by measuring the deviation amounts of the spot images P of a plurality of product samples with respect to the center point of the light receiving surface. Accordingly, the spot image P is hardly deviated to a neighborhood of the conceivable maximum value d. In the case where the light receiving surface of the photodiode is reduced beyond the variation range of the spot image P, the spot image P partially goes out from the light receiving surface when the deviation of the spot image P with respect to the photodiode becomes close to the maximum value d. However, a small amount of light is deviated from the light receiving surface when the light receiving surface of the photodiode is reduced to an extent shown by the regular octagon OT2. Even if the deviation is generated to an extent close to the maximum value d, a large part of the spot image P is formed in the photodiode because the center position of the spot image P is located in the neighborhood of the circumference of the circle c in Fig. 3B.

The shape of the regular octagon OT2 is formed by cutting out the corner portion of the rectangle RT along the straight line passing through the position slightly inside the variation range of the spot image P based on the conceivable maximum value of the deviation amount d, and the shape is applied to the element body of the photodiode 2. Even in this case, the spot image P is formed in any place of the light receiving surface, and the light receiving amount can stably be obtained.

Based on the above principle, the photodiode 2 in which the front surface and the rear surface and the cross-section between the front surface and the rear surface of the element body are formed into the regular octagonal shape is provided in the photo-IC 20 in Fig. 1B. The shapes and sizes of these surfaces correspond to the regular octagon OT2 (Fig. 3D) that is formed by cutting out each of the four corner portions of the minimum rectangle RT including the conceivable variation range of the spot image P along the straight line passing through the slight inside of the line indicated by the closed curve CV.

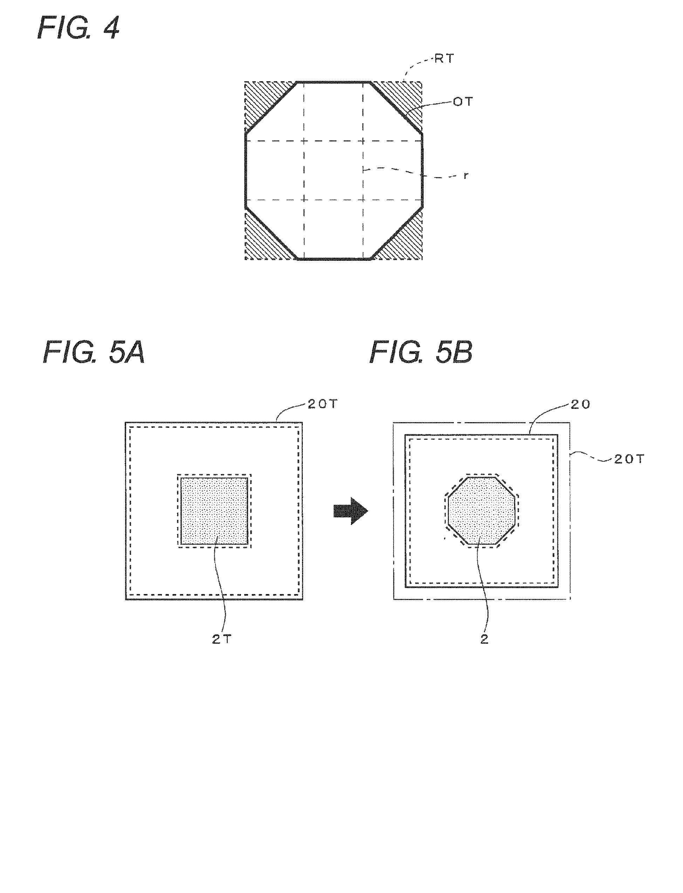

Fig. 4 illustrates a reduction amount generated by changing the shape of the outer edge portion of the element body of the photodiode 2 from the rectangle to the regular octagon. Specifically, in Fig. 4, the regular octagon OT2 applied to the photodiode 2 and the rectangle RT that becomes the reference of the regular octagon OT2 are illustrated while superimposed on each other, and a diagonal-line pattern is set in a gap between the regular octagon OT2 and the rectangle RT. Vertices opposed to each other in the regular octagon OT2 are connected by an alternate long and short dash line to divide the rectangle RT into nine square regions r.

As is clear from a comparison of each region r and the diagonal-line portion, an area corresponding to almost two regions r is reduced when the rectangle RT is changed to the regular octagon OT2. In terms of percentage, about 20% of the whole area of the rectangle RT is reduced.

Figs. 5A and 5B illustrate a comparison of a photo-IC 20T (Fig. 5A) including the square photodiode 2T (identical to that in Fig. 3A) to which the rectangle RT is applied and the photo-IC 20 (Fig. 5B) including the photodiode 2 to which the regular octagon OT2 is applied. The photodiodes 2T and 2 of the photo-ICs 20T and 20 are mounted on a silicon substrate (not illustrated), and a wiring pattern of a signal processing circuit is formed around each of the photodiodes 2T and 2 on the silicon substrate, and connected to an electrode on the photodiode side. In the photo-ICs 20T and 20 illustrated in Figs. 5A and 5B, a range where the wiring pattern of the signal processing circuit is formed is indicated by a dotted line.

In the photodiode 2 in which the thick portion of the element body is formed into the regular octagon OT2, the place corresponding to each of the four corner portions of the photodiode 2T becomes a vacant region, so that the wiring can be formed in each vacant region as illustrated in Fig. 5B. Thus, the outer edge portion of the wiring pattern can be greatly reduced by routing the wiring in the space generated by the reduction of the element body. As a result, as indicated by the alternate long and short dash line and the solid line in Fig. 5B, the main body of the photo-IC 20 can be made smaller than the photo-IC 20T in which the square photodiode 2T is used.

Because an area reduction rate in Fig. 4 can be applied to the whole thick portion of the element body of the photodiode, the area of the junction surface between the P-type semiconductor and the N-type semiconductor of the photodiode 2 to which the surface based on the regular octagon OT2 is applied is also reduced by about 20% compared with the photodiode 2T to which the surface based on the rectangle RT is applied. Therefore, a response to a control signal issuing an instruction to receive the light can be enhanced, because the parasitic capacitance of the photodiode 2 is also decreased by about 20%. In the case where a transimpedance amplifier is introduced to the signal processing circuit to convert a current signal obtained by the photoelectric conversion into a voltage signal, a noise component is greatly reduced, so that the detection can be stably performed.

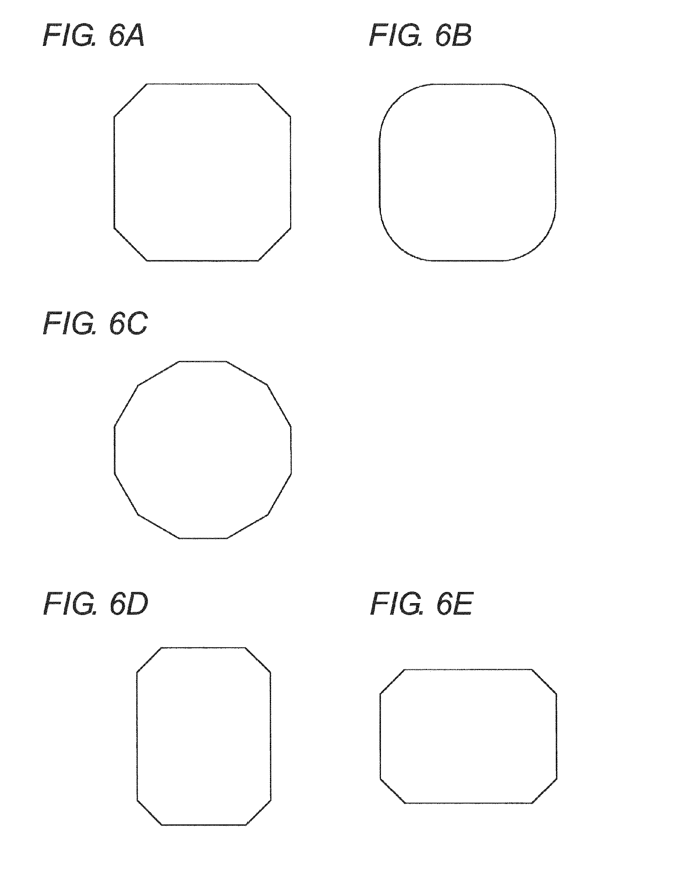

Figs. 6A to 6E illustrate other shapes that can be applied to the outer edge shape of the element body of the photodiode 2.
In the above embodiment, in consideration of the production efficiency, the regular octagon OT2 that is smaller than the closed curve CV indicating the variation range of the spot image P is applied to the outer edge portion of the element body of the photodiode 2. Alternatively, as illustrated in Figs. 6Ato 6E, an octagon in which a length of a side in an oblique direction is shorter than lengths of sides in vertical direction and horizontal directions correctly according to the closed curve CT may be used. The octagon corresponds to the octagon OT1 illustrated in Fig. 3C.

Alternatively, as illustrated in Fig. 6B, the cut-out portion in the corner portion of the rectangle RT may be rounded according to the closed curve CT.
Alternatively, each side may be formed while the angle is finely changed along the closed curve CT, whereby a polygonal shape having a larger number of corners than the octagon may be formed as illustrated in Fig. 6C.

Depending on the configuration of the optical system, the deviation amount of the spot image P may not be equalized in each direction or the spot image P elongated in one direction may be generated. Even in these cases, by obtaining the variation range of the spot image P based on the conceivable maximum value of the deviation of the image formation position, the shape in which the four corner portions of the rectangle are eliminated can be formed as illustrated in Figs. 6D and 6E, and this shape can be applied to the element body of the photodiode 2.

The shapes of the element body in Figs. 5B and Figs. 6A to 6D correspond to the shape in which the four corner portions of the minimum-size rectangle including the conceivable variation range of the spot image P are eliminated. Accordingly, the area corresponding to the total cut-out portions in the four corner portions can be reduced compared with the photodiode to which the pre-cut-out rectangle is applied. As a result, the photodiode 2 or the photo-IC 20 can be downsized within the range where the reflected light is received without any trouble, and the parasitic capacitance of the photodiode 2 can be decreased to improve the detection performance. However, it is not always necessary to eliminate all the four corner portions of the rectangle. For example, the shape in which only one corner portion is eliminated may be formed.

The photo-IC can be applied to not only the reflection-type photoelectric sensor but also a transmission-type photoelectric sensor as illustrated in Fig. 7. In the photoelectric sensor, the size and shape of the element body of the photodiode 2 can be determined by a method similar to the above-described examples based on the conceivable variation range of the spot image P, when a projector 101 in which the projection unit 10 (not illustrated in Fig. 7) is accommodated and an optical receiver 102 in which the photo-IC 20 is accommodated are opposed to each other with a predetermined distance.

## Claims

1. A photoelectric sensor comprising:
a projection element that emits detection light;
a silicon substrate on which a signal processing circuit is formed; and
a photo-IC that includes a photodiode mounted on the silicon substrate, wherein
the light emitted from the projection element or reflected light is received by the photodiode, and a detection signal is output in accordance with an output from the signal processing circuit that processes a light receiving amount signal generated by the light reception of the photodiode, and
in the photodiode of the photo-IC, an element body of the photodiode has a front surface, a rear surface, and a cross-section between the front surface and the rear surface formed into a shape of a rectangle in which at least one of four corners thereof is eliminated, the rectangle having an area larger than that of a spot image formed in the front surface of the element body by light passing through a light receiving lens in front.

2. The photoelectric sensor according to claim 1, wherein, by cutting out all the four corners of the rectangle, the element body of the photodiode has the front surface, the rear surface, and the cross-section between the front surface and the rear surface formed into an octagonal shape.

3. The photoelectric sensor according to claim 1 or 2, wherein a wiring pattern of the signal processing circuit is formed around the element body of the photodiode on the silicon substrate, and part of the wiring pattern of the signal processing circuit is disposed in a place that corresponds to the cut-out corner of the element body, and the place is on the silicon substrate.
